(19) Europäisches Patentamt
European Patent Office
Office européen des brevets

(11) Publication number: **0 488 372 A1**

(12) # EUROPEAN PATENT APPLICATION

(21) Application number: **91120519.3**

(51) Int. Cl.[5]: **G03F 7/11**, G03F 7/004

(22) Date of filing: **29.11.91**

(30) Priority: **30.11.90 JP 338147/90**

(43) Date of publication of application:
**03.06.92 Bulletin 92/23**

(84) Designated Contracting States:
**DE FR GB**

(71) Applicant: **MATSUSHITA ELECTRIC INDUSTRIAL CO., LTD**
**1006, Oaza Kadoma, Kadoma-shi**
**Osaka 571(JP)**

(72) Inventor: **Hashimoto, Kazuhiko**
**30-1-206, Keihan Hondori-1-chome**
**Moriguchi-shi(JP)**
Inventor: **Endo, Masayuki**
**782, Kurodoricho**
**Izumi-shi(JP)**

(74) Representative: **Patentanwälte Leinweber & Zimmermann**
**Rosental 7/II Aufg.**
**W-8000 München 2(DE)**

(54) **Fine pattern forming process.**

(57) A stable and accurate fine resist pattern which is not influenced by the time of standing from radiation exposure to heat treatment after radiation exposure, can be formed by coating a chemical amplification resist film containing an acid-generating agent with a water-soluble polymer resin incompatible with the resist film.

EP 0 488 372 A1

## BACKGROUND OF THE INVENTION

### Field of the Invention

The present invention relates to a fine pattern forming process using a light, X-rays or an electron beam, employed in the production of semi-conductor devices or integrated circuits. More particularly, the present invention relates to a fine pattern forming process employed in forming a pattern with a chemical amplification resist.

### Prior Art

In production of electronic devices such as IC, LSI and the like, formation of resist patterns has hitherto been conducted by photolithography using an ultraviolet light.

As the pattern dimensions of these devices have become finer, a stepper lens of higher numerical aperture, a light source of shorter wavelengths, etc. are used, but it invites a drawback of smaller focus depth.

Further, an electron beam lithography has come to be used as the pattern dimension of LSI devices has become finer and the production of ASIC has started. In the fine pattern formation by the electron beam lithography, a positive type electron beam resist is requisite. A polymethyl methacrylate (PMMA) is known as a positive type electron beam resist giving the highest resolution, but has a drawback of low sensitivity.

There have been presented, in recent years, many reports concerning the enhancement of sensitivity of positive type electron beam resists. These reports propose positive type electron beam resists using, for example, polybutyl methacrylate, copolymers of methyl methacrylate and methacrylic acid, copolymers of methacrylic acid and acrylonitrile, copolymers of methyl methacrylate and isobutylene, polybutene-1-sulfone, polyisopropenyl ketone or fluoro polmethacrylates. In all of these resists, in order to allow them to have a high sensitivity, an electron withdrawing group has been introduced into the side chain or an easily decomposable bond has been introduced into the principal chain to allow the principal chain to undergo easy scission by electron beam. However, they do not fully satisfy any of resolution and sensitivity. Further, these resists are not sufficiently good in dry etch durability and heat resistance. Consequently, it is difficult to use them as a mask for dry etching and their usages are limited.

Meanwhile, negative type electron beam resists using a cyclized rubber as a base have drawbacks in that they have low adhesion to a substrate, are difficult to form a uniform high-quality film with no pinholes, on a substrate, and have low thermal stability and resolution.

Therefore, various improvements have hitherto been made for negative type electron beam resists. As a result, there have been proposed negative type electron beam resists using, for example, polyglycidyl methacrylate, chloromethylated polystyrenes, chloromethylated $\alpha$-methyl polystyrenes, polymethacrylate-maleic acid esters, chlorinated polystyrenes or glycidyl methacrylate-ethyl acrylate copolymers. In all of these resists, electron-sensitive epoxy groups or chlorine atoms have been introduced in order to allow them to generate radicals easily when exposed to an electron beam and give rise to a crosslinking reaction. The above resists are intended to have a high sensitivity but are not sufficient in any of resolution and heat resistance. These negative type resists use a rubbery thermoplastic polymer containing a cyclized rubber or a polyisoprene as a base. In developing said resists, an organic solvent is required as a developer. In some cases, this organic solvent developer causes the swelling of an image-written resist during the development of the resist, which reduces the resolution of pattern and may invite distortion of pattern, making the pattern unusable. Moreover, the organic solvent developer is harmful from standpoints of environment and human health and additionally may invite fire.

Hence, as in photolithography, chemical amplification resists have been developed also in electron beam lithography (W.E. Feely et al., Polymer Engineering and Science, 26, 1101 (1986)). Chemical amplification positive resists consist of two components, i.e. an acid-generating agent and an acid degradable polymer, or three components, i.e. an acid-generating agent, an acid degradable polymer and a solubility inhibitor. Chemical amplification negative resists consist of three components, i.e. an acid-generating agent, an acid reactive monomer and an acid crosslinkable polymer. These resists have a high sensitivity because they contain an acid-generating agent, and have good heat resistance and dry etch durability because they contain a novolak resin or the like. Moreover, these resists enable pattern formation using an aqueous alkali solution as a developer. Various researches are under way for the development of chemical amplification resists which are practically usable.

In chemical amplification resists, the pattern formation takes place based on the following mechanism. That is, the acid-generating agent contained in the chemical amplification resist generates an acid when

exposed to a radiation and, in the subsequent heat treatment, the acid reacts with a polymer also contained in the resist, to form a positive pattern, or gives rise to a crosslinking reaction with a monomer contained in the resist (as a result, polymerization takes place) to form a negative pattern. Accordingly, unless the acid generated by radiation exposure and the monomer or polymer in the resist are reacted by a heat treatment right after the radiation exposure, the acid reacts with $O_2$ or $CO_2$ in the air or with an amine and is deactivated, resulting in no pattern formation. Thus, as shown in the case of the conventional process of Fig. 2, when the time of standing from the radiation exposure to the heat treatment after the radiation exposure is long, the generated acid disappears and formation of resist pattern becomes difficult even if a heat treatment is conducted for acceleration of a desired reaction.

The electron beam lithography has various drawbacks such as poor dry etch durability and heat resistance of electron beam resist, adverse effect of proximity effect caused by forward or backward scattering of electron on pattern precision, adverse effect of charging of incident electron on image writing, and the like. In order to improve these drawbacks, use of a multi-layer resist consisting of an imaging layer and a planarizing layer is very effective. Fig. 4 shows illustrations explaining a process for forming a multi-layer resist by electron beam lithography. In order to expect a reduced proximity effect, an organic polymer film as a bottom layer 41 is formed on a substrate 11 in a thickness of 2-3 $\mu$m and then a heat treatment is conducted [Fig. 4A]. Thereon is formed, as an intermediate layer 42, an inorganic film of $SiO_2$ or the like or an inorganic polymer film of SOG (spin-on-glass) or the like in a thickness of 0.2 $\mu$m. Thereon is formed, as a top layer 43, an electron beam resist in a thickness of 0.5 $\mu$m. Thereon is vapor-deposited a thin aluminum layer 44 in a thickness of about 100 A, in order to prevent charging [Fig. 4B]. Electron beam writing is conducted. Then, the thin aluminum layer is removed with an aqueous alkali solution, followed by development, to obtain a resist pattern 43P [Fig. 4C]. Thereafter, the intermediate layer is dry-etched using the resist pattern as a mask, after which the bottom layer is dry-etched using the intermediate layer as a mask [Fig. 4D]. By employing the above process using a multi-layer resist, a fine pattern can be formed at a high aspect ratio.

However, in the process using a multi-layer resist on which aluminum is vapor-deposited, the steps are more complex; aluminum contamination is high; change in resist dimension during pattern transfer is large; thus, the process using a multi-layer resist is not practical. Further in the process, an aqueous alkali solution is used for removal of thin aluminum layer; therefore, no novolak type resist can be used in the process because the novolak type resist requires an aqueous organic alkali solution as a developer. In the process using a multi-layer resist having no thin aluminum layer, there is a problem of charging. This charging is a phenomenon in which incident electrons are accumulated in the resist, the intermediate layer or the bottom layer, all being an insulator. The charging invites serious problems in electron beam lithography, for example, reduction in butting accuracy and overlay accuracy. The charging is also seen in a single-layer resist and, as in the tri-layer resist, invites reduction in butting accuracy and overlay accuracy.

That is, in electron beam lithography, incident electrons are scattered in the resist but stop at a depth of 1-1.5 $\mu$m from the resist surface, whereby the incident electrons are accumulated in the resist portions from the surface to said depth. It is thought that these accumulated electrons cause deflection of electron beam, which in turn invites reduction in butting accuracy and overlay accuracy.

In order to solve the above-mentioned problems, the present inventors completed a fine pattern forming process which can form an accurate pattern stably and easily.

## SUMMARY OF THE INVENTION

The present invention provides a process for forming a fine pattern, which comprises

coating a semiconductor substrate with a chemical amplification resist containing an acid-generating agent as a component, to form a resist film and then heat-treating the film,

coating the resist film with water-soluble polymer resin incompatible with the resist film in order to protect an acid to be generated in the resist film in the subsequent step of exposing the resist film to a radiation, from $O_2$ or $CO_2$ in the air or from an amine,

exposing the resist film to a radiation in a particular pattern and then removing the water-soluble polymer resin,

heat-treating the resist film to form a latent image of the pattern in the resist film, and then

developing the resist film with an aqueous alkali solution to form a resist pattern on the substrate. In the present process, there is coated a chemical amplification resist film with a water-soluble polymer resin incompatible with the resist film, to protect the acid generated in the resist film, from $O_2$ or $CO_2$ in the air or from an amine and prevent the acid from being deactivated. Desirably, the water-soluble polymer resin consists of an ion conductive or electron conductive polymer. As the radiation, an electron beam is used,

but a light or X-rays can also be used.

The present invention further provides a process for forming a fine pattern, which comprises

forming an organic polymer film on a semi-conductor substrate,

forming, on the organic polymer film, an inorganic film or an inorganic polymer film,

coating the inorganic film or the inorganic polymer film with a chemical amplification resist containing an acid-generating agent as a component, to form a resist film and then heat-treating the resist film,

coating the resist film with a water-soluble polymer resin incompatible with the resist film in order to protect an acid to be generated in the resist film in the subsequent step of exposing the resist film to a radiation, from $O_2$ or $CO_2$ in the air or from an amine,

exposing the resist film to a radiation in a particular pattern and then heat-treating the resist film,

removing the water-soluble polymer resin and then developing the resist film with an aqueous alkali solution to form a resist pattern, and

subjecting the inorganic film or inorganic polymer film and the organic polymer film to etching by using the resist pattern as a mask.

According to the process of the present invention, even when an unstable chemical amplification resist is used, there can be formed a stable and accurate resist pattern which is not influenced by the time of standing from radiation exposure to heat treatment after radiation exposure. Specifically, the water-soluble polymer resin has no compatibility with the resist film and can be easily removed with water, whereby the process steps are simplified and an accurate fine pattern can be formed stably. In photolithography, by forming a film of the above water-soluble polymer resin, a standing-wave effect can also be suppressed, whereby an accurate pattern can be formed.

In electron beam lithography, by allowing the water-soluble polymer resin to have conductivity, pattern distortion by charging can be easily prevented and an accurate pattern can be formed. In this case, it is not necessary to vapor-deposit aluminum in order to prevent charging; resultantly, there arises no aluminum contamination and the process steps can be simplified. Accordingly, the use of the present process enables the formation of an accurate fine pattern of high resolution.

## BRIEF DESCRIPTION OF THE DRAWINGS

Figs. 1A to 1D are sectional views showing an example of the steps of the pattern forming process of the present invention.

Fig. 2 is a graph showing the relations between the dimension of resist pattern and the time of standing from radiation exposure to heat treatment after radiation exposure, in the present process and the conventional process.

Figs. 3A to 3D are sectional views showing other example of the steps of the pattern forming process of the present invention.

Figs. 4A to 4D are sectional views showing the steps of the conventional pattern forming process using a multi-layer resist.

## DESCRIPTION OF THE PREFERRED EMBODIMENTS

The present invention is intended to solve the above-mentioned problems by coating a chemical amplification resist film containing an acid-generating agent as one component with a water-soluble polymer resin incompatible (immiscible) with the resist film.

As mentioned above, the chemical amplification positive resists consist of two components, i.e. an acid-generating agent and an acid degradable polymer, or three components, i.e. an acid-generating agent, an acid degradable polymer and a solubility inhibitor. The chemical amplification negative resists consist of three components, i.e. an acid-generating agent, an acid reactive monomer and an acid crosslinkable polymer. Both of these resists are water-insoluble.

Typical examples of the acid-generating agent are sulfonium salts such as

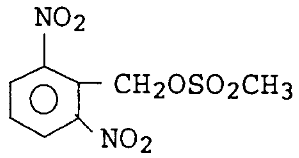

and

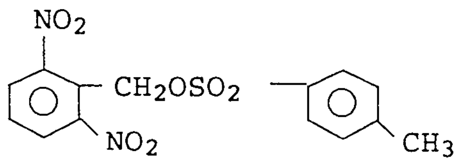

and other onium salts such as

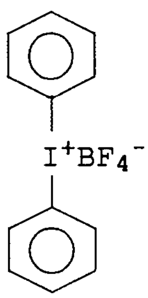 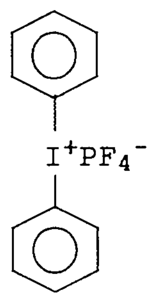 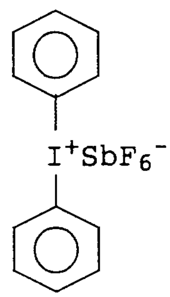 and 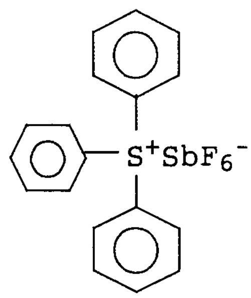 .

Each of these sulfonium and other onium salts generates a Lewis acid (a strong acid) when exposed to a light or an electron beam.

In the case of, for example, the chemical amplification positive resist, the acid degradable polymer is degraded by the Lewis acid.

Examples of the acid degradable polymer are as follows.

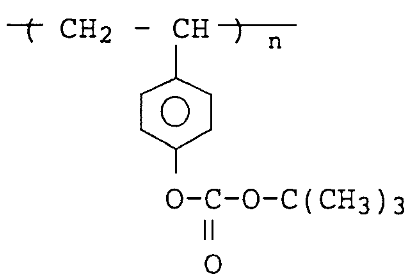 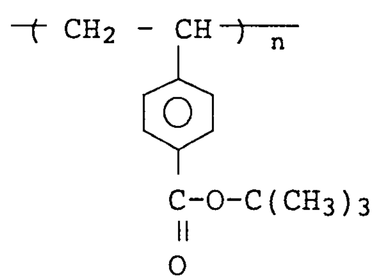

Each of these polymers is converted to an alkali-soluble polymer by, for example, the following reaction scheme in the presence of the above acid.

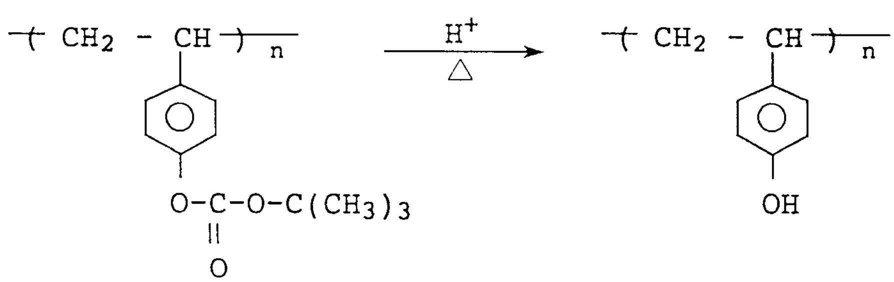


In the above reaction, heat is necessary in order to supply a sufficient activation energy. However, when the generated acid is allowed to stand in the air for a long time before the heating, the acid is deactivated.

Not only in the chemical amplification positive resist but also in other cases, the acid which is generated from the acid-generating agent contained in the resist when the resist has been exposed to a radiation such as light (e.g. ultraviolet light), electron beam, X-rays or the like, reacts gradually with $O_2$ or

$CO_2$ in the air or with an amine and comes to be deactivated when allowed to stand in the air for a long time. In such a case, no pattern is formed by the heat treatment after radiation exposure. To avoid this, a water-soluble polymer resin is applied on the resist film to prevent the resist film from contacting directly with the air and is removed with water before development, whereby the acid generated in the resist by radiation exposure can be protected from being reacted with $O_2$ or $CO_2$ in the air or with an amine, i.e. from being deactivated. As a result, a stable resist pattern can be formed without being influenced by the time of standing from radiation exposure to heat treatment after radiation exposure.

The water-soluble polymer resin can be any as long as it is a water-soluble polymer immiscible with the resist film. It may be, for example, a polyvinyl alcohol but is desirably an ion conductive or electron conductive polymer in order to prevent the charging due to electron beam. The ion conductive or electron conductive polymer includes, for example, the followings:

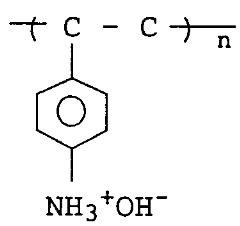
,
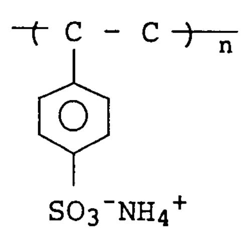

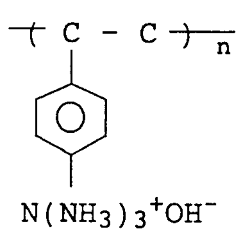
,
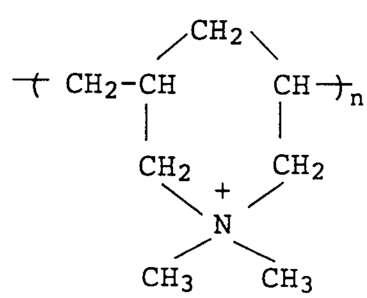

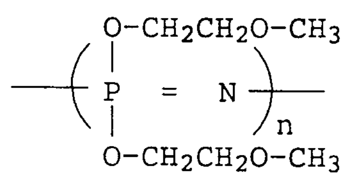
,
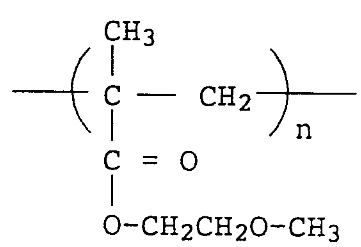

wherein n is a positive integer.

In the present invention, the semiconductor substrate includes a silicon substrate, etc.

The organic polymer includes those generally used as a resist in photolithography, such as novolak resin and the like.

The inorganic film includes films composed of $SiO_2$, W, Al, etc. The inorganic polymer film includes films composed of a polysiloxane, SOG (spin-on-glass), etc.

In the present invention, an aqueous alkali solution is used as a developer. It is typically an aqueous tetramethylammonium hydroxide solution or the like.

Example 1

The present example is explained with reference to Fig. 1. On a silicon substrate 11 is applied, as an electron beam resist 12, a chemical amplification positive resist consisting of a sulfonium salt

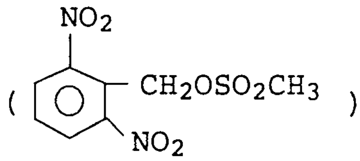

as an acid-generating agent and a t-butoxycarbonyl-protected polystyrene as an acid degradable polymer, in a thickness of 1.0 µm. The applied resist was heat-treated at 90 °C for 90 seconds [Fig. 1A]. On the resulting resist film was applied a polystyrene ammonium salt as a water-soluble polymer film 13 in a thickness of 0.2 µm. Then, image writing with an electron beam 14 was conducted at an accelerating voltage of 30 kV at a dose of 10 $\mu C/cm^2$ [Fig. 1B]. Then, the water-soluble polymer film was removed with water, after which a heat treatment was conducted at 100 °C for 90 seconds to accelerate the reaction between the acid degradable polymer and the acid generated in the resist to form a latent image 12P in the resist [Fig. 1C]. The resist was developed with an aqueous organic alkali solution, whereby a stable fine positive resist pattern 12R could be formed accurately at a high sensitivity [Fig. 1D].

Fig. 2 shows relations between the dimension of resist pattern and the time of standing from electron beam exposure to heat treatment after the exposure. In Fig. 2, the broken line indicates the process using the conventional chemical amplification resist and the solid line indicates this Example using the novel process of the present invention. It is clear that in the conventional process, as the time of standing gets longer, the acid in the resist film is deactivated to a higher extent, making the formed resist pattern more inaccurate, while in the present process, the formed resist pattern has an accurate and constant dimension regardless of the length of the time of standing. Thus, it was found that the deactivation of the generated acid can be prevented by forming the water-soluble polymer film on the resist film. Further, since the water-soluble polymer film had ion conductivity, charge up could be prevented at the time of electron beam writing, which made it possible to obtain an accurate resist pattern having no distortion.

Example 2

The same procedure as in Example 1 was repeated except that a polyvinyl alcohol was used as a water-soluble polymer in place of the polystyrene ammonium and that a far-ultraviolet light having a wavelength of 248 nm was used in place of the electron beam. As a result, an accurate positive pattern could be formed.

Example 3

The present Example is explained with reference to Fig. 3. On a semiconductor substrate 11 was applied, as a bottom layer film 31, a novolak resin in a thickness of 2 µm. The applied resin was heat-treated at 220 °C for 90 seconds. Thereon was formed, as an intermediate layer film 32, a $SiO_2$ film in a thickness of 0.2 µm. The $SiO_2$ film may be replaced by other inorganic polymer film. On the intermediate layer film was applied, as an electron beam resist top layer film 33, a chemical amplification negative resist consisting of an acid-generating agent, an acid reactive monomer and an acid crosslinkable polymer in a thickness of 0.5 µm. The resist top layer film was heat-treated at 90 °C for 90 seconds [Fig. 3A]. On the resist film 33 was applied, as a water-soluble polymer film 34, a polystyrene sulfonium salt in a thickness of 0.2 µm. Then, image writing was conducted on the resist 33 with an electron beam 35 at an accelerating voltage of 30 kv at a dose of 10 $\mu C/cm^2$ [Fig. 3B].

Then, a heat treatment was conducted, after which the water-soluble polymer film 34 was removed with water. A heat treatment after exposure was conducted at 100 °C for 90 seconds to react the acid generated in the resist, with the monomer to form a latent image in the resist film 33. Thereafter, development was conducted using an aqueous organic alkali solution, whereby a stable fine negative resist pattern 33P could be formed accurately at a high sensitivity [Fig. 3C]. Using this resist pattern 33P as a mask, the intermediate layer and the bottom layer were subjected to dry etching, whereby an accurate vertical fine resist pattern could be obtained [Fig. 3D].

Since the water-soluble polymer film 34 had an ion conductivity, charging could be prevented at the time of image writing with electron beam, which made it possible to obtain an accurate resist pattern having no distortion. Further, the dimension of resist pattern was found to be the same when comparison was made between (a) a case where the resist film 33 covered with the water-soluble polymer film 34 was allowed to stand in the air for 100 hours from the exposure to the heat treatment after the exposure and (b)

a case where the same resist was not allowed to stand in the air.

The same results can be obtained when the above procedure is repeated by replacing the electron beam by a light or X-rays.

## Claims

1. A process for forming a fine pattern, which comprises
   coating a semiconductor substrate with a chemical amplification resist containing an acid-generating agent as a component, to form a resist film and then heat-treating the film,
   coating the resist film with a water-soluble polymer resin incompatible with the resist film in order to protect an acid to be generated in the resist film in the subsequent step of exposing the resist film to a radiation, from $O_2$ or $CO_2$ in the air or from an amine,
   exposing the resist film to a radiation in a pattern and then removing the water-soluble polymer resin,
   heat-treating the resist film to form a latent image of the pattern in the resist film, and
   developing the resist film with an aqueous alkali solution to form a resist pattern on the substrate.

2. A process for forming a fine pattern according to Claim 1, wherein the resist film is exposed to an electron beam in a pattern and the water-soluble polymer resin is an ion conductive or electron conductive polymer.

3. A process for forming a fine pattern, which comprises
   forming an organic polymer film on a semiconductor substrate,
   forming, on the organic polymer film, an inorganic film or an inorganic polymer film,
   coating the inorganic film or the inorganic polymer film with a chemical amplification resist containing an acid-generating agent as a component, to form a resist film and then heat-treating the resist film,
   coating the resist film with a water-soluble polymer resin incompatible with the resist film in order to protect an acid to be generated in the resist film in the subsequent step of exposing the resist film to a radiation, from $O_2$ or $CO_2$ in the air or from an amine,
   exposing the resist film to a radiation in a pattern and then heat-treating the resist film,
   removing the water-soluble polymer resin and then developing the resist film with an aqueous alkali solution to form a resist pattern, and
   subjecting the inorganic film or inorganic polymer film and the organic polymer film to etching by using the resist pattern as a mask.

4. A process for forming a fine pattern according to Claim 3, wherein the resist film is exposed to an electron beam in a pattern and the water-soluble polymer resin is an ion conductive or electron conductive polymer.

FIG. 1A

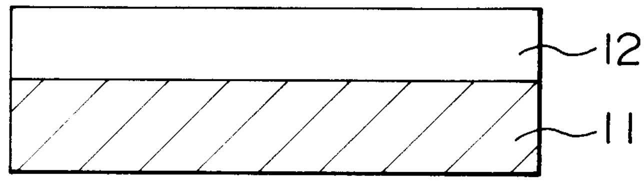


FIG. 1B

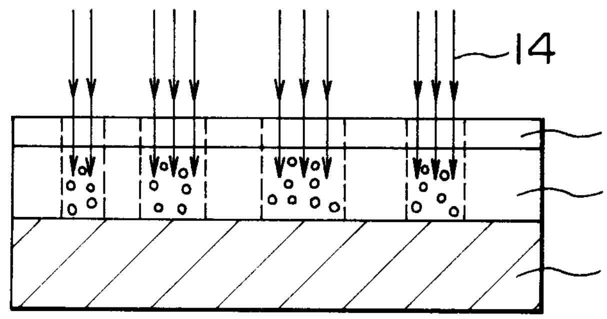


FIG. 1C

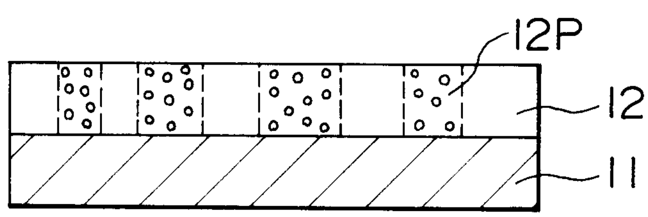


FIG. 1D

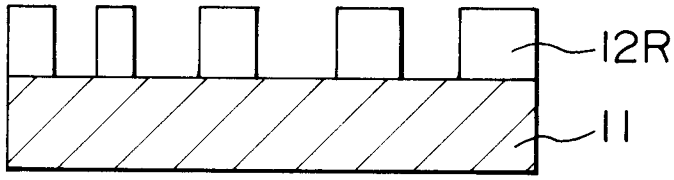

FIG. 2

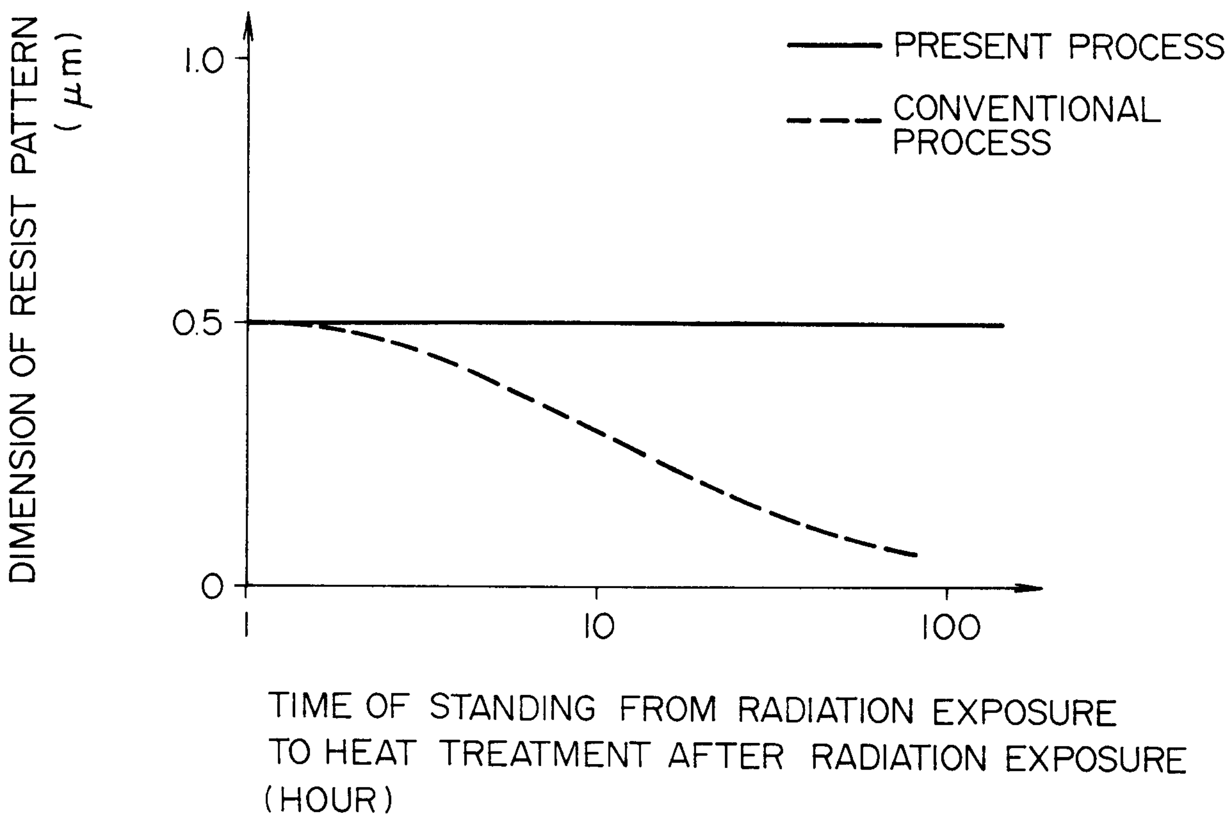
DIMENSION OF RESIST PATTERN
( μm)
1.0
0.5
0
1
10
100
PRESENT PROCESS
CONVENTIONAL PROCESS
TIME OF STANDING FROM RADIATION EXPOSURE
TO HEAT TREATMENT AFTER RADIATION EXPOSURE
(HOUR)

FIG. 3A

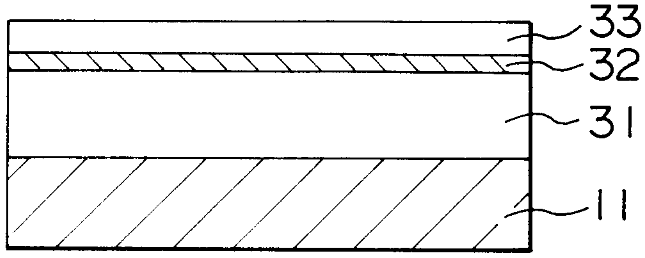


FIG. 3B

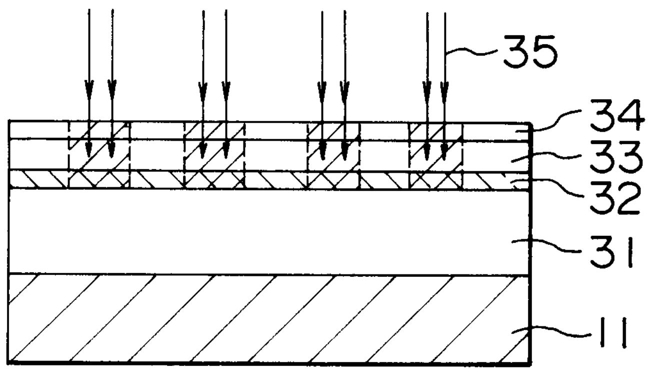


FIG. 3C

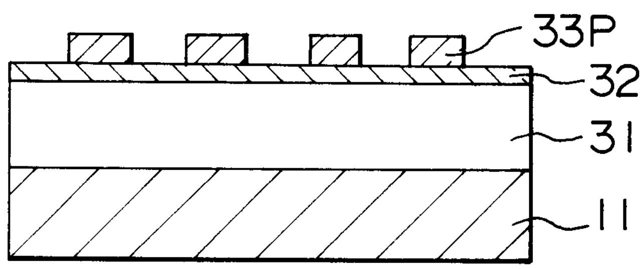


FIG. 3D

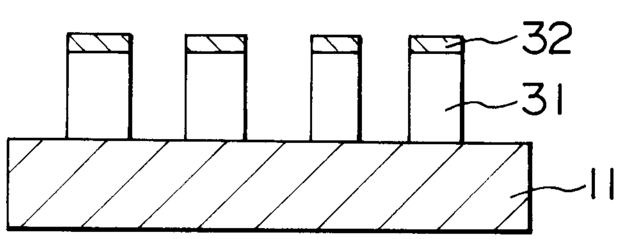

FIG. 4A PRIOR ART

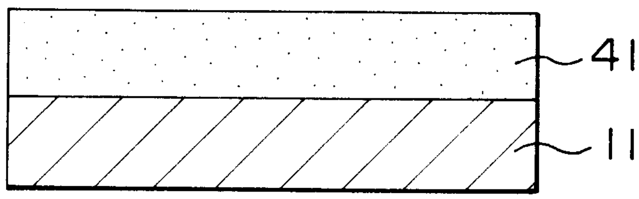


FIG. 4B PRIOR ART

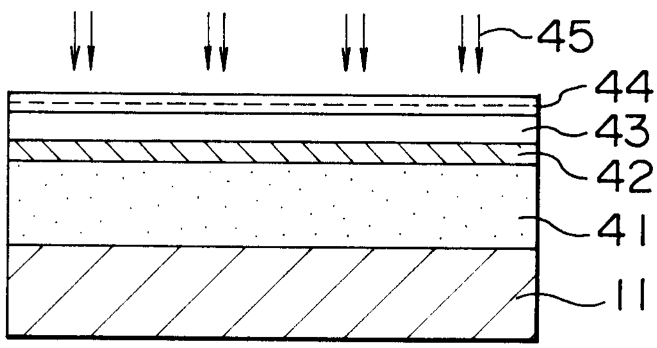


FIG. 4C PRIOR ART

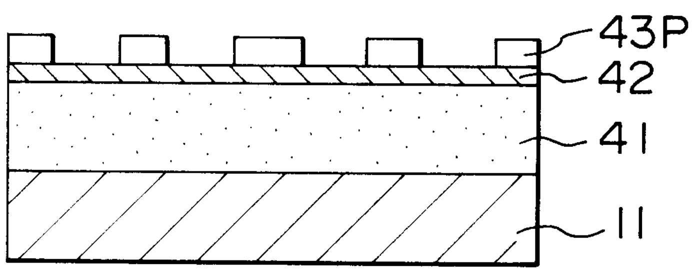


FIG. 4D PRIOR ART

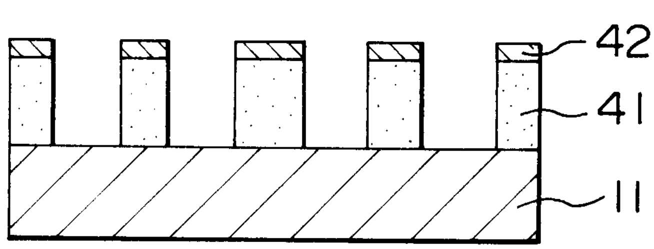

European Patent Office

# EUROPEAN SEARCH REPORT

Application Number

EP 91 12 0519

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | EP-A-0 348 961 (MATSUSHITA ELECTRIC INDUSTRIAL CO LTD)<br>* examples 9,10 *<br>--- | 1-4 | G03F7/11<br>G03F7/004 |
| A | FR-A-2 305 757 (HOECHST AG)<br>* claims *<br>--- | 1-4 | |
| A | INSTITUTE OF ELECTRICAL AND ELECTRONICS ENGINEERS 'INTERNATIONAL ELECTRON DEVICES MEETING'<br>1987 , WASHINGTON DC<br>* page 753 - page 756 *<br>--- | 1-4 | |
| P,A | EP-A-0 440 376 (MATSUSHITA ELECTRIC INDUSTRIAL CO LTD)<br>* claims *<br>----- | 1 | |
| | | | TECHNICAL FIELDS SEARCHED (Int. Cl.5 ) |
| | | | G03F |

The present search report has been drawn up for all claims

| Place of search | Date of completion of the search | Examiner |
|---|---|---|
| THE HAGUE | 30 MARCH 1992 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)